# EUROPÄISCHE PATENTSCHRIFT

(11) **EP 0 796 521 B1**
(45) Veröffentlichungstag und Bekanntmachung des Hinweises auf die Patenterteilung: **14.03.2001**
(21) Anmeldenummer: 95941652.0
(22) Anmeldetag: 01.12.1995
(51) Int. Cl.: H03C 3/00, H02J 13/00

(54) **VORRICHTUNG ZUR STÖRSICHEREN MODULATION UND DEMODULATION VON ANALOGEN SIGNALEN ZUR NACHRICHTENÜBERTRAGUNG ÜBER DIE SCHIRMUNGEN VON ENERGIEÜBERTRAGUNGSKABELN**
DEVICE FOR THE NOISE-FREE MODULATION AND DEMODULATION OF ANALOGUE SIGNALS USED FOR TRANSMITTING INFORMATION ALONG THE SHIELDING OF POWER TRANSMISSION CABLES
DISPOSITIF DE MODULATION ET DE DEMODULATION SANS BRUIT DE SIGNAUX ANALOGIQUES UTILISES POUR LA TRANSMISSION D'INFORMATIONS AU MOYEN DES BLINDAGES DE CABLES DE TRANSPORT D'ENERGIE

(30) Priorität: 08.12.1994 EP 94119418
(43) Veröffentlichungstag der Anmeldung: 24.09.1997
(73) Patentinhaber: SIEMENS AKTIENGESELLSCHAFT, 80333 München (DE)
(72) Erfinder: OECHSLE, Walter, D-90765 Fürth (DE); LINDNER, Hans-Peter, D-90766 Fürth (DE)
(86) Internationale Anmeldenummer: EP9504751
(87) Internationale Veröffentlichungsnummer: WO9618238

(56) Entgegenhaltungen:
- EP-A- 0 352 660
- EP-A- 0 560 071

## Beschreibung

Die Erfindung betrifft eine Schaltung, welche an Schnittstellen zwischen den als Übertragungsstrecken dienenden Schirmungen von Energieübertragungskabeln und den Einrichtungen zur Vorgabe und Verarbeitung der jeweiligen Nachrichten, in der Regel Digitalrechner, für die Einspeisung bzw. den Empfang der in Form von analogen, frequenzmodulierten Signalen vorliegenden Nachrichten benötigt wird. Auf der Sendeseite der Schaltung dient sie zur Generierung der Signale aus aktuellen digitalen Vorgabewerten, d.h. zur sogenannten Modulation. Auf der Empfangsseite der Schaltung dient sie zur Rückgewinnung der digitalen Vorgabewerte aus empfangenen analogen Signalen, d.h. zur sogenannten Demodulation. Eine derartige Schaltung wird häufig auch als ein Modem bzw. eine Modemschaltung bezeichnet.

Bei der Modulation werden im Sendeteil eines Modems sinusförmige, analoge Signale mit zwei unterschiedlichen Sendefrequenzen gebildet, welche als Ober- und Unterfrequenz bezeichnet werden können. Der hochfrequente Takt der Umschaltung zwischen den Sendefrequenzen, d.h. die eine Frequenzmodulation darstellende Umtastung, ist vom aktuellen Bitmuster des jeweiligen digitalen Vorgabewertes abhängig. Dabei wird den beiden binären Wertigkeiten jeweils eine Sendefrequenz eindeutig zugeordnet. Bei der Demodulation im Empfangsteil eines Modems wird erkannt, welche der beiden Sendefrequenzen aktuell empfangen wird. Dieser wird dann der entsprechende binäre Wert zugeordnet. Aus der Folge der auf diese Weise entstehenden binären Werten wird schließlich der die jeweilige Nachricht darstellende digitale Vorgabewert rekonstruiert.

Die Schaltung gemäß der Erfindung wird eingesetzt speziell bei der sogenannten Kabelschirmkommunikation. Dabei werden die Nachrichten in Form von analogen, frequenzmodulierten Signalen über die Schirmungen insbesondere von zur Energieverteilung dienenden Hochspannungskabeln übertragen. Bei den Nachrichten handelt es sich in der Regel um Steuer- und Zustandsmeldesignale. Dabei werden Steuersignale meist von einem Zentralrechner erzeugt und dienen zur Steuerung von Netzbetriebsmitteln im Energieverteilungsnetz, z.B. von Stufentransformatoren, Leistungsschaltern und dergleichen. Andererseits können derartige Nachrichten auch Zustandsmeldesignale sein, womit der aktuelle Betriebszustand des Energieverteilungsnetzes durch die darin verteilt angeordneten Netzbetriebsmittel dem Zentralrechner mitgeteilt werden.

Bei der Kabelschirmkommunikation besteht ein Problem darin, daß die Energieübertragungskabel in der Regel Bestandteil eines weit verzweigten Kabelnetzes sind, welches insbesondere in Städten zur Energieversorgung dient. Aus diesem Grund erfolgt die Übertragung der oben genannten Steuer- und Zustandsmeldesignale über Kabelschirmungen nicht in Form einer einfachen Punkt zu Punkt Übertragung. Vielmehr müssen die analogen, frequenzmodulierten Signale mit Hilfe von sogenannten Relaisstationen über die Schirmungen einer Kette von miteinander verbundenen Energieübertragungskabeln weitergereicht werden, bis sie die Zielrelaisstation erreichen. Meist befindet sich an jedem Knotenpunkt des Energieübertragungsnetzes, d.h. an jeder Stelle, an der mindestens zwei Kabelenden zusammentreffen, eine derartige Relaisstation. Diese hat die Aufgabe, mit Hilfe jeweils einer integrierten Modemschaltung von der Schirmung eines Energieübertragungskabels analoge, frequenzmodulierte Signale zu empfangen und die dazugehörigen digitalen Vorgabewerte zu rekonstruieren. Diese werden in einem lokalen Digitalrechner des Modems ausgewertet. Die Modemschaltung muß somit in die Richtung aller angeschlossener Kabelschirme empfangsbereit sein.

Die Nachrichten können an die gerade empfangende Relaisstation gerichtet sein. Die hieraus rekonstruierten digitalen Vorgabewerte können sich dann z.B. als Steuersignale herausstellen, welche das im jeweiligen Netzpunkt befindliche Netzbetriebsmittel betreffen. Andererseits kann es sich z.B. um Steuersignale handeln, welche vom Zentralrechner an ein in einem anderen Netzpunkt befindliches Netzbetriebsmittel gerichtet sind, bzw. z.B. um Zustandsmeldesignale, welche von einem, in einem bestimmten anderen Netzpunkt befindlichen Netzbetriebsmittel an den Zentralrechner gerichtet sind. In diesen Fällen müssen die analogen, frequenzmodulierten Signale von jeder Relaisstation aus der Richtung eines Energieübertragungskabels empfangen und demoduliert werden. Erst nun ist eine Erkennung von deren, an eine andere Relaisstation bzw. an den Zentralrechner gerichtete Adressierung im lokalen Digitalrechner des jeweiligen Modems möglich. Diese werden nun erneut moduliert und in der Richtung des entsprechenden Energieübertragungskabels in dessen Kabelschirm eingespeist. Es ist auch möglich, daß ein Netzbetriebsmittel selbständig eine Zustandsmeldung generiert, welche dann über das Modem der lokalen Relaisstation meist in Richtung auf den Zentralrechner in den Kabelschirm des entsprechenden Energieübertragungskabels einspeist.

Das zur Übertragung dienende Kabelschirmnetz weist somit eine ganz besondere Topologie auf. Diese ist insbesondere gekennzeichnet durch die mit Relaisstationen und jeweils einer integrierten Modemschaltung besetzten Schnittstellen der Kabelschirmungen in den Knotenpunkten des Energieübertragungsnetzes. Diese stellen Unterbrechungspunkte in der aus der Kette von Kabelschirmungen bestehenden Übertragungsstrecke dar. Aus diesem Grund sind insbesondere hohe Anforderungen an die Güte der Nachrichtenübertragung zu stellen. Die Modulation und Demodulation im Modem einer jeden Relaisstation muß somit besonders robust sein, d.h. unempfindlich gegen die Einkopplung von Störungen, die bei der Übertragung in irgend einen Kabelschirm bzw. an einem der vielen Knotenpunkte auftreten können.

Der Erfindung liegt die Aufgabe zugrunde, eine möglichst einfache Modemschaltung anzugeben, mit der eine Nachrichteneinund auskopplung in die bzw. aus den Schirmungen von Energieübertragungskabel dennoch mit hoher Störsicherheit möglich ist.

Die Aufgabe wird gelöst mit der im Anspruch 1 angegebenen Schaltung. Vorteilhafte weitere Ausführungsformen sind in der Unteransprüchen angegeben.

Aus dem Dokument EP 0560071A ist eine Vorrichtung zur störsicheren Modulation und Demodulation bekannt, die einen digitalen Modulator und Demodulator und Mittel zur Erzeugung eines zentralen Präzisionstaktes aufweist. Auf der Empfangsseite dieser bekannten Vorrichtung ist aber kein getaktetes Bandpaßfilter und Schmidt-Trigger vorhanden.

Die Erfindung und vorteilhafte weitere Ausführungsformen der Erfindung werden anhand der nachfolgend kurz angeführten Figuren näher erläutert. Dabei zeigt
- Fig. 1 :: ein Blockschaltbild der erfindungsgemäßen Modemschaltung für die Nachrichteneinspeisung in bzw. Auskopplung aus den Schirmungen von Energieübertragungskabeln,
- Fig.2 :: eine vorteilhafte Ausführung eines getakteten Bandpaßfilters in der erfindungsgemäßen Modemschaltung,
- Fig.3 :: das Signalverhalten einer vorteilhaften Ausführungsform eines Schmitt-Triggers im Empfangsteil der erfindungsgemäßen Modemschaltung,
- Fig.4 :: das Signalverhalten am Eingang einer vorteilhaften Ausführungsform eines digitalen Demodulators im Empfangsteil der erfindungsgemäßen Modemschaltung,
- Fig.5 :: das Signalverhalten einer vorteilhaften Ausführungsform eines digitalen Modulators im Sendeteil der erfindungsgemäßen Modemschaltung,
- Fig.6 :: das Signalverhalten einer vorteilhaften Ausführungsform eines Tiefpaßfilters am Ausgang des Sendeteiles der erfindungsgemäßen Modemschaltung, und
- Fig.7 :: das Beispiel einer zweikanaligen Ausführung der erfindungsgemäßen Modemschaltung.

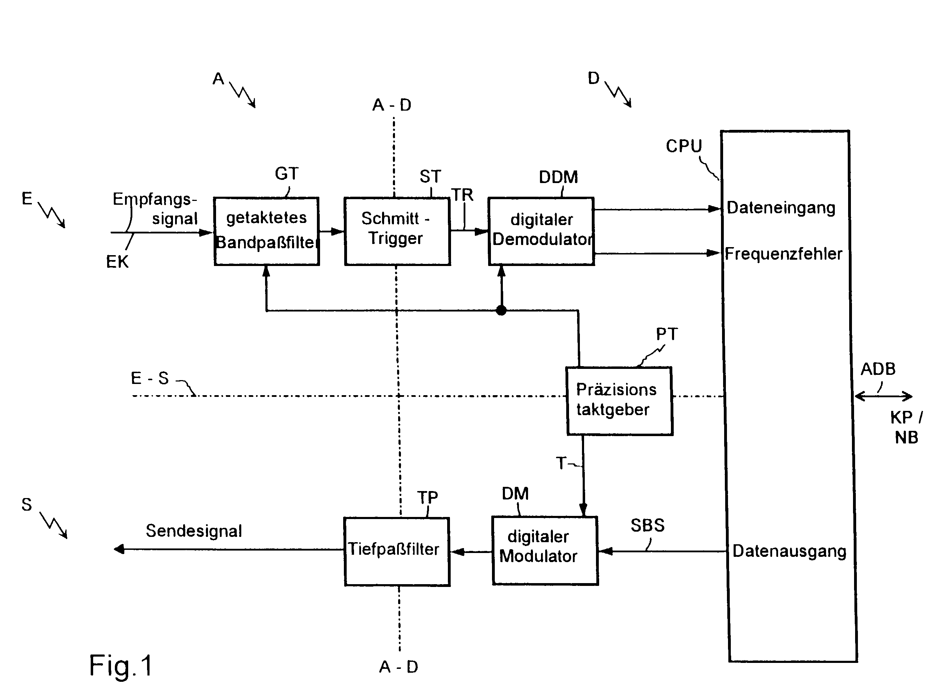

Figur 1 zeigt das Blockschaltbild der erfindungsgemäßen Modemschaltung. Zur besseren Übersicht sind in dieses eine vertikale Trennungslinie A-D und eine horizontale Trennungslinie E-S eingetragen. Mit der horizontalen Trennungslinie E-S wird der Empfangsteil E und der Sendeteil S der Modemschaltung abgegrenzt. Mit der vertikalen Trennungslinie A-D werden im Empfangs- und Sendeteil E,S der Modemschaltung zusätzlich abgegrenzt je ein analoger Teil A und ein digitaler Teil D, d.h. je ein Teil, in dem analoge Signalverarbeitung bzw. digitale Signalverarbeitung durchgeführt wird.

Dem Empfangsteil E der erfindungsgemäßen Schaltung werden die analogen, von einem anderen Modem ins Energieübertragungsnetz eingespeisten, frequenzumgetasteten Signale als Empfangssignale EK aus der Schirmung des jeweils benachbarten, lokalen Energieübertragungskabels entnommen und in Figur 1 auf der linken Seite zugeführt. Diese werden im analogen Teil des Empfangsteiles E in einem über einen zentralen Präzisionstakt T getakteten Bandpaßfilter GT aufbereitet und einem die Schnittstelle zwischen analogem und digitalem Teil des Empfangsteiles E bildenden Schmitt-Trigger ST zugeführt. Dieser leitet aus den aufbereiteten analogen Empfangssignalen rechteckförmige Triggersignale TR ab, welche einem digitalen Demodulator DDM, der ebenfalls vom zentralen Präzisionstakt T betrieben wird, als Steuersignale zugeführt werden. Dieser demoduliert die Triggersignale TR durch Bestimmung der aktuellen Sendefrequenz der Empfangssignale, d.h. Detektion der Ober- bzw. Unterfrequenz, und ordnet diesen den jeweiligen binären Wert zu. Der auf diese Weise entstehende Strom demodulierten Bits wird in Form eines seriellen Empfangsbitstromes EBS einem lokalen Rechner CPU an dessen Dateneingang zugeführt. Dieser decodiert schließlich aus dem aktuellen "Muster" des Bitstromes EBS die eigentliche Vorgabewerte, d.h. den jeweiligen Nachrichteninhalt.

Falls ein Modem der in Figur 1 dargestellten Art in einer sogenannten Kopfstation enthalten ist, kommuniziert der Rechner CPU über einen Ausgangsdatenbus ADB in der Regel mit einem Zentralrechner KP. Dieser organisiert die Nachrichtenübertragung und damit die Steuerung eines gesamten Energieübertragungskabelnetzes. Andererseits ist in jeder der im Energieübertragungskabelnetz verteilten Relaisstationen ein Modem entsprechend der Schaltung von Fig. 1 enthalten. In diesem Fall kommuniziert der Rechner CPU über den Ausgangsdatenbus ADB mit den Steuerelementen des jeweiligen Netzbetriebsmittels.

Im Sendeteil S der erfindungsgemäßen Schaltung von Figur 1 werden aktualisierte digitale Vorgabewerte vom lokalen Rechner CPU des Modems in Form eines bevorzugt pulspausenmodulierten seriellen Sendebitstromes SBS einem digitalen Modulator DM zugeführt, welcher ebenfalls vom zentralen Präzisionstakt T betrieben wird. Am Ausgang des digitalen Modulators DM werden abhängig von der aktuellen Wertigkeit des Sendebitstromes SBS Rechtecksignale generiert, welche die Ober- bzw. Unterfrequenz aufweisen. Diese werden schließlich in einem die Schnittstelle zwischen digitalem und analogem Teil des Sendeteiles S der erfindungsgemäßen Schaltung darstellenden Tiefpaßfilter TP in sinusförmige Sendesignale umgewandelt und anschließend in die Schirmung von Energieübertragungskabeln eingespeist.

Kernstück der erfindungsgemäßen Modemschaltung ist die Steuerung der wesentlichen Elemente der Schaltung sowohl auf der Empfangsseite E als auch auf der Sendeseite S über einen zentralen Präzisionssteuertakt T als eine gemeinsame Zeitbasis bzw. Referenz. Dieser wird zumindest dem getakteten Bandpaßfilter GT, dem digitalen Demodulator DDM und dem digitalen Modulator DM als eine gemeinsame Zeitbasis zugeführt. Alle diese Elemente können aus dieser Zeitbasis jeweils benötigte, unterschiedliche Frequenzen hochgenau ableiten. Aufgrund dieser engen Abstimmung der wesentlichen Elemente aufeinander, und insbesondere der von diesen durchführten Vorgängen der Modulation auf der Sendeseite und der Demodulation auf der Empfangsseite, ist eine besonders präzise Modulation und Demodulation übertragener Signale möglich, d.h. eine schmalbandige und damit störsichere Übertragung insgesamt. Der zentrale Präzisionssteuertakt T kann von einem separaten Präzisionstaktgeber PT bereitgestellt werden, wie dies im Beispiel der Fig. 1 dargestellt ist. Andererseits besteht auch die Möglichkeit, daß der Präzisionstakt im Rechner CPU hochgenau generiert wird.

Die erfindungsgemäße zentrale Generierung eines Präzisionssteuertaktes T für alle wesentlichen Elemente der Modemschaltung von Figur 1 hat ein Vielzahl von Vorteilen. Zum einen wird der Schaltungsaufwand bei der Signalaufbereitung auf der analogen Seite A des Empfangsteils E durch die Ermöglichung des Einsatzes eines getakteten Bandpaßfilters GT zur Aufbereitung der Empfangssignale EK, und auf der digitalen Seite A des Empfangsteils E durch die Ermöglichung des Einsatzes eines digitalen Demodulators DDM erheblich reduziert. In der gleichen Weise wird auf der Sendeseite S durch die Ermöglichung des Einsatzes eines digitalen Modulators DM der Schaltungsaufwand erheblich reduziert.

Dennoch wird mit dem erfindungsgemäßen Schaltungskonzept eine erhebliche Verbesserung der Störunempfindlichkeit bei der Signalverarbeitung sowohl auf Seite der Demodulation empfangener Signale, als auch bei Modulation von zu sendenden Signalen erreicht. Die Verbesserung in der Güte bei der Modulation zu sendender Signale kommt wiederum der Signalverarbeitung auf der Empfangsseite einer anderen, an einer anderen Stelle des Energieverteilungsnetzes in einer Relaisstation angeordneten Modemschaltung bei dem dort stattfindenden Empfang und der Demodulation zu gute. Dies ist auf die starre Verkopplung der Empfangsseite E und der Sendeseite S über den zentralen Präzisionssteuertakt T zurückzuführen. Je genauer die Umsetzung des Sendebitstromes SBS auf der Sendeseite S in analoge, sinusförmige Sendesignale bezogen auf den zentralen Präzisionssteuertakt T erfolgt, um so leichter und genauer kann Empfang, Aufbereitung und Rekonstruktion eines äquivalenten Empfangsbitstromes EBS in einem entsprechenden Modem an anderer Stelle des Energieübertragungsnetzes erfolgen. Die erfindungsgemäße Gestaltung der Modemschaltung kommt somit der Übertragungsgüte der gesamten Nachrichtenübertragung über die Kabelschirmungen der Energieübertragungskabel zu Gute. Dies bewirkt insbesondere eine geringere Empfindlichkeit der Schaltung gegenüber der Einkopplung von Störungen, welche gerade bei einer Nachrichtenübertragung über die Schirmungen von Energieübertragungskabeln in einem besonders starken Ausmaß auftreten können.

Ferner wird es durch das erfindungsgemäße Schaltungskonzept möglich, eine besonders schmalbandige Übertragung zu realisieren. Das Schaltungskonzept gemäß der Erfindung ist somit besonders geeignet für den Einsatz von zwei wertemäßig eng beieinander liegenden Kennfrequenzen. Ober- und Unterfrequenz können somit lediglich durch einen ungewöhnlich geringen Trägerfrequenzhub von z.B. etwa 0,5 Kiloherz getrennt sein. Durch die quasi synchrone Steuerung des getakteten Bandpaßfilters GT, des digitalen Demodulators DDM und des digitalen Modulator DM über den zentralen Präzisionstakt T kann nämlich eine besonders hohe Frequenzstabilität erreicht werden. Es ist somit möglich, auch eng beieinander liegende Ober- und Unterfrequenzen auf der Sendeseite auf einfache Weise zu modulieren und insbesondere auf der Empfangsseite einfach und störsicher wieder zu demodulieren. Die Unterdrückung von Störungen, welche in die analogen frequenzmodulierten Signale auf den Schirmungen der Energieübertragungskabel eingekoppelt werden, ist somit besonders effektiv.

Das getaktete Bandpaßfilter GT im analogen Teil A des Empfangsteiles E der erfindungsgemäßen Schaltung hat zumindest die Aufgabe, die analogen Empfangssignale EK derart aufzubereiten, daß darin enthaltene störende hohe Frequenzanteile und störende niedere Frequenzanteile, welche Gleichspannungsoffset ähnlich sind, ausgefiltert werden. Das Frequenzspektrum der gefilterten analogen Signale ist somit derart beschnitten, daß nur noch Frequenzen aus einem Bereich enthalten sind, der möglichst eng um die zwischen den bei der Modulation eingesetzten Werten von Ober- und Unterfrequenz liegt. Die Mittenfrequenz des getakteten Bandpaßfilters GT wird erfindungsgemäß vom zentralen Präzisionstaktgeber PT der Schaltung abgeleitet. Da hiermit die Mittenfrequenz sehr genau und stabil vorgebbar ist, kann die Übertragung vorteilhaft schmalbandig ausgelegt werden. Die Filtermittenfrequenz liegt dann möglichst genau in der Mitte von Ober- und Unterfrequenz, zwischen denen bei der Modulation und Demodulation umgetastet wird. Hierdurch wird die Störsicherheit der Datenübertragung erheblich verbessert.

Die durch das getaktete Bandpaßfilter GT aufbereiteten analoge Empfangssignale EK werden nun einem Schmitt-Trigger ST zugeführt. Dieser bildet die Schnittstelle zwischen analogem Teil A und digitalem Teil D der erfindungsgemäßen Schaltung. Der Schmitt-Trigger ST enthält mindestens einen Komparator, womit die aufbereiteten Empfangssignale EK in mindestens ein frequenzgleiches Rechtecksignal TR umgewandelt werden. Dieses dient wiederum zur Triggerung des nachfolgenden digitalen Demodulators DDM.

Der digitale Demodulator DDM hat die Aufgabe, die Frequenz der analogen Empfangssignale EK zu erfassen und dieser möglichst den Wert Ober- bzw. Unterfrequenz eindeutig zuzuordnen. Hierzu verfügt der digitale Demodulator zumindest über einen Referenzzähler, dem das Triggersignal TR vom Schmitt-Trigger ST zugeführt wird. Dieser zählt die Periodendauer einer jeden Schwingung, d.h. die den Abstand der Triggersignale TR aus, so daß sich ein Frequenzmeßwert ergibt. Erfindungsgemäß wird der Zähltakt des Referenzzählers ebenfalls vom zentralen Präzisionstakt T des Präzisionstaktgebers PT bestimmt. Auch hierbei erfüllt der Präzisionstakt T wieder die Funktion einer zentralen Zeitbasis für die gesamte Modemschaltung. Damit lassen sich die für die Frequenzerkennung notwendigen Frequenzmarken präzise einstellen. Der Hub der Trägerfrequenz kann somit klein sein, so daß die hierdurch erreichte Schmalbandigkeit der Übertragung eine erhebliche Verbesserung der Störunempfindlichkeit der erfindungsgemäßen Modemschaltung bewirkt. Aufgrund der digitalen Ausführung des Demodulators DDM treten ferner keine Toleranzen, Temperaturdriftungen und alterungsbedingte Pegelverschiebungen auf. Der Hardwareaufwand wird durch diese Ausführung ohne Einbußen in der Demodulationsgenauigkeit stark reduziert. Der digitale Demodulator läßt sich mit einfachen digitalen Bausteinen wie z.B. Gattern, Flip-Flops, Zählern realisieren. Im Gegensatz dazu ist bei bekannten Demodulatorschaltungen, z.B. bei einem Zwischenfrequenzdemodulator, einem Quadraturdekoder oder einem Phase Locked Loop Demodulator der Hardwareaufwand erheblich größer.

Die erfindungsgemäße Schaltung ist an die speziellen, bei der Datenübertragung über die Schirmungen von Hochspannungskabeln vorliegenden Randbedingungen optimal angepaßt. Mit der oben geschilderten Modemschaltung kann trotz reduziertem Hardwareaufwand eine besonders hohe Störsicherheit bei der Datenübertragung durch ein schmalbandiges Übertragunpsspektrum erreicht.

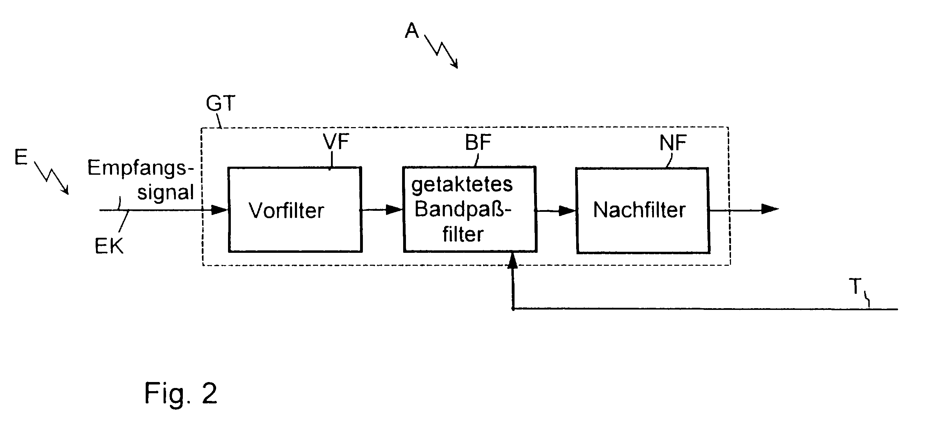

Bevorzugte weitere Ausführungsformen der Erfindung werden unter anderem an Hand der nachfolgenden Figuren 2 bis 7 erläutert.

Vorteilhaft wird das getaktete Bandpaßfilter GT in Form eines getakteten Kondensatorfilters realisiert. Derartige Filter werden auch als "Switched Capacitor Filter" bezeichnet. Bei diesem getakteten Filter kann bei der Bestimmung der Frequenzeigenschaften auf eine äußere Beschaltung mit realen Kondensatoren verzichtet werden. Diese müßten sehr genau sein, ein gutes Temperatur- und Alterungsverhalten aufweisen und wären somit teuer. Die Lage der Polstellen des Filters wird vielmehr durch den Wert des zentralen Präzisionstaktes T und eine einfache, äußere Widerstandsbeschaltung bestimmt. Trotz des einfachen Aufbaus eines derartigen Filters verfügt dieses über eine sehr hohe Güte und reproduzierbare Filtereigenschaften. Es ist vorteilhaft, wenn das getaktete Bandpaßfilter GT aus einer Kaskade von mehreren Teilfiltern besteht. Es kann z.B. als ein Block aus vier universalen switched-capacitor-Teilfiltern aufgebaut sein. Vorteilhaft werden dabei die vier Teilfilter kaskadiert und die Polstellen der Teilfilter aufeinandergelegt. Hierdurch kann trotz begrenzter Güten der Teilfilter insgesamt eine gute Frequenzselektivität erreicht werden. Bei einem Trägerfrequenzhub von z.B. etwa 0,5 Kiloherz beträgt die Bandbreite des getakteten Bandpaßfilters bevorzugt etwa 1,8 kHz.

Vorteilhaft kann das getaktete Bandpaßfilter GT durch ein zusätzliches Vorfilter und gegebenenfalls eine zusätzliches Nachfilter ergänzt werden. Eine derartige Filterkette GT ist im Beispiel der Figur 2 dargestellt und besteht auf einem Vorfilter VF, dem eigentlichen getakteten Bandpaßfilter BF und einem Nachfilter NF.

Die aus der Schirmung eines Energieübertragungskabels entnommenen analogen Empfangssignale EK werden vorteilhaft in einem die Eigenschaften eines Bandpasses aufweisenden Vorfilter VF einer ersten Bearbeitung unterzogen. Durch Ausnutzung der Tiefpaßeigenschaften des Vorfilters können besonders hohe, störende Frequenzanteile zur Vermeidung von deren Einschleifung gleich am Eingang der erfindungsgemäßen Modemschaltung ausgefiltert werden. Hierdurch wird die Störempfindlichkeit der Schaltung verbessert. Ferner werden Gestaltung und Dimensionierung der weiteren Elemente im Empfangsteil der Schaltung, insbesondere des getakteten Bandpaßfilters BF und des digitalen Demodulators DDM erheblich vereinfacht. Durch Ausnutzung der Hochpaßeigenschaften des Vorfilters kann ein sogenannter Gleichanteil, auch Offset genannt, im unteren Frequenzbereich unterdrückt werden. Auch hierdurch werden Gestaltung und Dimensionierung der weiteren Schaltungsteile erheblich vereinfacht und insbesondere deren Wirkungsweise verbessert, da durch die Vermeidung eines möglichen Gleichanteiles die Eingangsdynamik an nachfolgenden Filtern aufrechterhalten werden kann.

Vorteilhaft wird das Vorfilter VF in Form eines aktiven, kontinuierlichen Bandpaßfilters bevorzugt 1. Ordnung ausgeführt und z.B. mit einem Operationsverstärker und RC-Beschaltung realisiert. Dieses kann u.a. vorteilhaft als sogenanntes Anti-Aliasing-Filter für das nachfolgende getaktete Bandpaßfilter BF dienen. Da die eigentliche "Filterarbeit" vom nachfolgenden, getakteten Bandpaßfilter BF geleistet wird, dessen Filtermittenfrequenz über den zentralen Präzisionstakt T exakt auf die jeweils vorliegenden Werte der Ober- und Unterfrequenz abgestimmt ist, müssen die Bandbreite bzw. die Eckfrequenzen des Vorfilters VF nicht genau auf die bei der Modulation und Demodulation vorliegenden Frequenzverhältnisse abgestimmt sein. Aufwendige Schaltungsmaßnahmen zu deren Konstanthaltung können somit vorteilhaft vermieden werden. Auch für die Unterdrückung eines Gleichanteiles ist eine nur annähernde Abstimmung ausreichend.

Vorteilhaft enthält das Vorfilter VF zusätzlich Mittel zur Einstellung der Verstärkung. Hiermit kann der Signalpegel der empfangenen, analogen Eingangssignale EK an den Eingangsspannungsbereich der nachfolgenden Elemente der Schaltung, insbesondere des Bandpaßfilters, angepaßt werden. Es wird damit vorteilhaft einerseits ein für die weitere Signalverarbeitung benötigter Mindestwert des Signalpegel sichergestellt. Andererseits wird vermieden, daß durch Überschreitung eines maximalen Signalpegels die im Empfangsteil der erfindungsgemäßen Modemschaltung folgenden Elemente übersteuert werden. Die Einstellung der Verstärkung bereits im Vorfilter VF hat den besonderen Vorteil, daß in der weiteren Schaltung keine Verstärkungen mehr vorgenommen werden müssen. Die Verstärkung der analogen Empfangssignale EK bereits im Vorfilter VF hat Vorteil, daß eine Verstärkung des von den weiteren Elementen im Empfangsteil E der Schaltung erzeugte Rauschen, insbesondere das Rauschen des getakteten Bandpaßfilters BF, dessen Maximum gerade im eigenen Durchlaßbereich liegt, nicht mitverstärkt wird. Der Signal-Rauschabstand kann hiermit erheblich verbessert werden.

Vorteilhaft können die analogen Eingangssignale durch ein zusätzliches Nachfilter NF im Anschluß an das getaktete Bandpaßfilter BF weiter aufbereitet werden. Zum einen kann hiermit ein insbesondere bei Ausführung des getakteten Bandpaßfilters BF als Switched Capacitor Filter möglicherweise an dessen Ausgang auftretendes Rauschen gedämpft werden, welches auch als Taktdurchgriff oder Übersprechen des Bandpaßtaktes bezeichnet wird. Zum anderen kann hiermit ein im getakteten Bandpaßfilter BF möglicherweise entstehender Gleichanteil unterdrückt werden, so daß das Empfangssignal symmetrisch zur Bezugsmasse der Schaltung bleibt. Rauschfreie und symmetrische Empfangssignale begünstigen deren fehlerfreie Umwandlung in Rechtecksignale im nachfolgenden Schmitt-Trigger ST. Das Nachfilter NF kann vorteilhaft als aktives, kontinuierliches Bandpaßfilter bevorzugt 1. Ordnung z.B. mit einem Operationsverstärker und RC-Beschaltung realisiert werden. Aufgrund der vorteilhaften Struktur der erfindungsgemäßen Modemschaltung sind wie beim Vorfilter VF auch beim Nachfilter NF keine hohen Anforderungen an die Einhaltung genauer Werte von Bandbreite bzw. Eckfrequenzen zu stellen.

Das gemäß der Darstellung in Fig. 2 bevorzugt aus einer Kette von Vorfilter VF, getaktetem Bandpaßfilter BF und Nachfilter NF bestehende getaktete Bandpaßfilter GT bereitet die analogen Empfangssignale EK derart auf, daß störende hohe Frequenzanteile und niederfrequente, gleichspannungsähnliche Offsetanteile ausgefiltert sind, und daß die Signale eine zur analogen Bezugsmasse der Schaltung symmetrische sinusförmige Gestalt aufweisen.

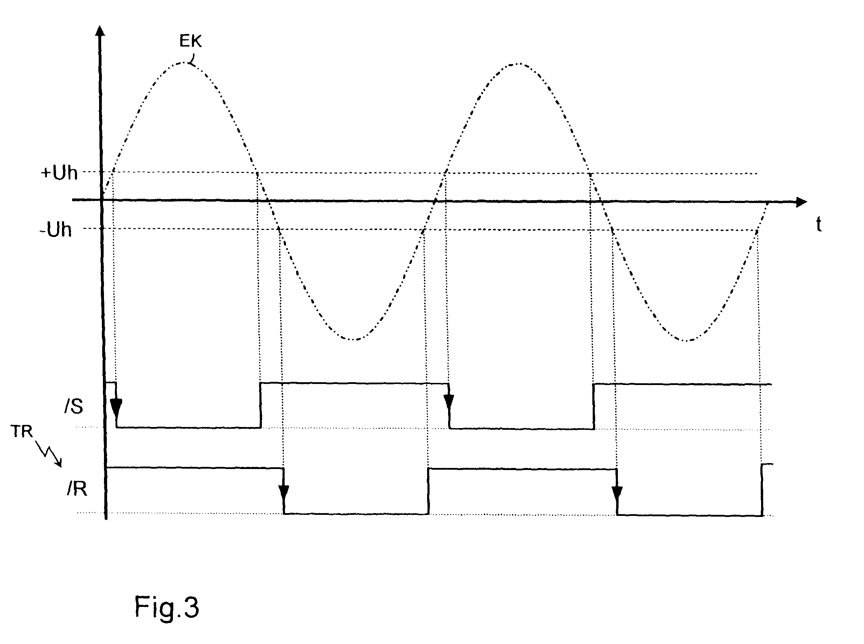

Das Signalverhalten eines bevorzugten Ausführungsbeispieles für einen Schmitt-Trigger ST ist Fig. 3 dargestellt. Dieser bildet die Schnittstelle zwischen analogem und digitalem Empfangsteil E. Ein über das getaktete Bandpaßfilter GT gefilterte, sinusförmige und zur analogen Masse der Modemschaltung symmetrische Empfangssignal EK wird im Schmitt-Trigger ST bevorzugt mittels zweier Komparatoren in zwei komplementäre, frequenzgleiche Rechtecksignale /S und /R umgewandelt. Diese sind ein digitalisiertes Abbild des analogen Empfangssignals EK. Die Rechtecksignale /S und /R stellen bei dieser Ausführung das Ausgangssignal " TR " des Schmitt-Triggers ST dar.

Vorteilhaft weist der Schmitt-Trigger zusätzlich Mittel auf, womit den Komparatoren je ein über bzw. unterhalb der Bezugsmasse der Modemschaltung liegender Schwellspannungswert +Uh bzw. -Uh vorgegeben werden kann. Dies hat zur Folge, daß die Komparatoren nicht am Nullgang des sinusförmigen Empfangssignales EK schalten, sondern erst jeweils bei Erreichen einer Schwellspannung +Uh bzw. -Uh. Die dadurch hervorgerufene Schalthysterese bewirkt ein vom sogenannten Grundrauschen unabhängiges, flatterfreies Schalten des Schmitt-Triggers. Damit wird in vorteilhafter Weise eine Rauschunterdrückung bewirkt. Der Betrag der Schwellspannung Uh ist bevorzugt einstellbar. Damit läßt sich die Empfindlichkeit des Schmitt-Triggers ST auf die aktuellen Rauschverhälnisse auf den als Übertragungsstrecke dienenden Kabelschirmungen abstimmen. Darüber hinaus ist aber eine präzise Einstellung der beiden Schwellspannungen bezüglich der Frequenzerkennung nicht erforderlich. Da die Komparatoren im Schmitt-Trigger in jeder Periode an der gleichen Stelle schalten, wirkt sich der Betrag der Schwellspannung nicht auf die Frequenz der Rechtecksignale /S, /R aus. Deren Frequenz bleibt erhalten und damit ihre Funktion als frequenzgleiche Triggersignale für den digitalen Demodulator DDM.

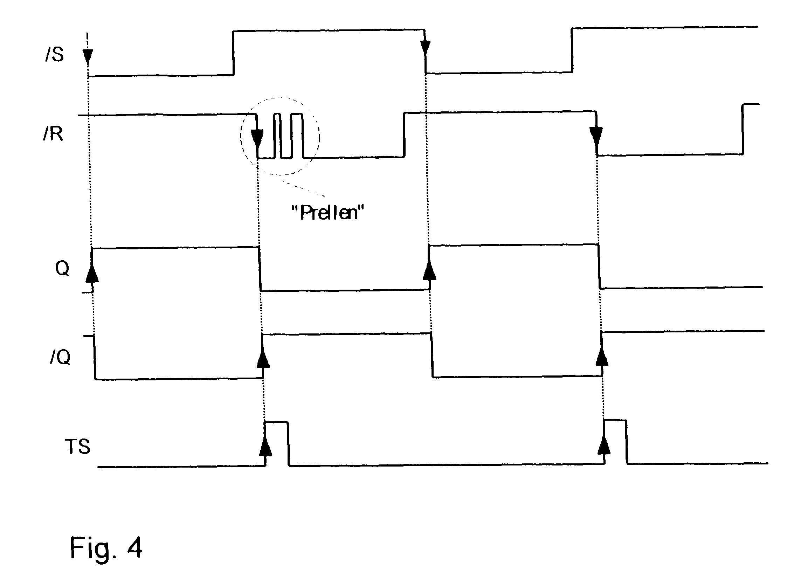

Das Signalverhalten am Eingang einer bevorzugten Ausführungform des digitalen Demodulators DDM ist Beispiel der Fig.4 dargestellt.

Der digitale Demodulator DDM gemäß dieser Ausführung weist an seinem Eingang bevorzugt ein RS-Flip-Flop auf, dessen pegelsensitiven Set- und Reset-Eingängen die Triggersignale /S und /R des Schmitt-Triggers ST zugeführt werden. Dadurch werden die komplementären Flip-Flop-Ausgänge Q und /Q gesetzt. Durch ein Flip-Flop mit pegelaktiven Set- und Reset-Eingängen wird vorteilhaft eine eventuell noch vorhandene Schwingung in den /S- und /R-Signalen, in Figur 4 mit Prellen bezeichnet, unterdrückt. Nachfolgend werden im digitalen Demodulator DDM die positiven Flanken des /Q-Signals differenziert und daraus ein internes Triggersignal TS erzeugt. Dessen Frequenz entspricht der Frequenz eines analogen Emfangssignals EK.

Eine Ablaufsteuerung im digitalen Demodulator DDM wird mit jeder positiven Flanke des interen TS Triggersignals getriggert. Die Zeit zwischen den positiven Triggerflanken kann mit einem von zentralen Präzisionstakt T getriebenen Referenzzähler gemessen bzw. der Zählerstand kann durch einen digitalen Fensterkomparator ausgewertet werden.

Dabei wird der Zählerstand des Referenzzählers bevorzugt mit drei Vergleichswerten verglichen, welche drei Frequenzmarken entsprechen. Hierdurch wird quasi ein doppeltes Frequenzfenster gebildet. Eine der drei Frequenzmarken dient als sogenannte Mittenfrequenz zwischen der Ober- und Unterfrequenz. Damit ist es im Demodulator möglich, zu erkennen, ob eine empfangene Momentanfrequenz größer oder kleiner als die Mittenfrequenz ist, und somit entweder der Oberfrequenz oder der Unterfrequenz zuzuordnen ist. Zur Begrenzung dieses doppelten Frequenzfensters dienen eine zusätzliche Oberfrequenzgrenze und eine zusätzliche Unterfrequenzgrenze. Nun ist es im Demodulator auch möglich, zu erkennen, ob eine außerhalb des zulässigen Wertebereiches liegende, unzulässige Frequenz empfangen wurde, d.h. ob die aktuelle Momentanfrequenz größer als die Oberfrequenzgrenze oder kleiner als die Unterfrequenzgrenze ist. Liegt einer der beiden Fälle vor, so wird ein Frequenzfehlersignal generiert. Hiermit kann das Vorliegen einer gestörten Übertragung signalisiert werden. Dies stellt somit ein weiteres Mittel dar, um die Sicherheit der Übertragung zu erhöhen. Die Eckfrequenzen eines Fensterkomparators können ebenfalls über den zentralen Präzisionstakt T eingestellt werden.

Im Sendeteil S der erfindungsgemäßen Schaltung von Figur 1 werden die am Datenausgang des Rechners CPU ausgegebenen digitalen Vorgabewerte von einem digitalen Modulator DM in analoge Sinusschwingungen umgesetzt, deren Frequenz entsprechend dem seriellen Sendebitstrom SBS zwischen Ober- und Unterfrequenz umgetastet wird. Hierzu enthält der Modulator vorteilhaft einen digitalen Frequenzgenerator, der zwischen den beiden Kennfrequenzen umgetastet wird. Aufgrund des erfindungsgemäßen Schaltungskonzeptes ist der digitale Frequenzgenerator sehr frequenzgenau, da die jeweiligen Werte von Ober- und Unterfrequenz im Modulator erfindungsgemäß aus dem zentralen Präzisionstakt T angeleitet werden. Der digitale Frequenzgenerator tastet näherungsweise unverzögert zwischen den beiden Kennfrequenzen um.

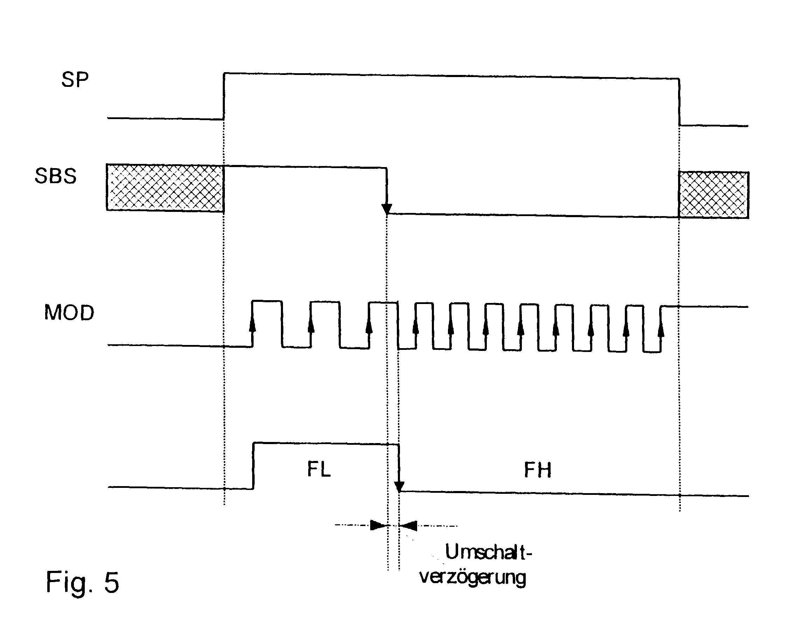

Das Signalverhalten einer vorteilhaften Ausführungsform eines digitalen Modulators DM im Sendeteil S der erfindungsgemäßen Modemschaltung ist beispielhaft in Fig.5 dargestellt.

Bei dem digitalen Modulator DM wird bevorzugt das sogenannte Continuous Phase Frequency Shift Keying Modulationsverfahren angewendet. Dabei wird zwischen Oberfrequenz FL und Unterfrequenz FH umgeschaltet. Nach Aktivierung des digitalen Modulators DM über ein Steuersignal SP wird entsprechend dem jeweiligen logischen Pegel des dem digitalen Modulator DM vom Rechner CPU seriell zugeführten Sendebitstromes SBS die Ober-bzw. Unterfrequenz erzeugt. Im Beispiel der Fig.5 weist das aktuelle Bit des Sendebitstromes SBS nach Freigabe des Modulators einen hohen Pegel auf. Für diese Zeit wird beispielhaft ein analoges Signal gesendet, welches die Unterfrequenz FL aufweist. In der zweiten Hälfte des Freigabezeitraumes des Modulators weist das aktuelle Bit des Sendebitstromes SBS einen niedrigen Pegel auf. Für diese Zeit wird dann ein analoges Signal gesendet, welches die Oberfrequent FH aufweist. Die Umtastung zwischen Ober- und Unterfrequenz FL und FH ist in Fig. 5 auch im Verlauf des Sendebitstromes SBS durch eine fallende Flanke markiert.

Vorteilhaft erfolgt die Frequenzumtastung bei Auftreten eines Nulldurchganges im jeweils aktiven Oberfrequenz- oder Unterfrequenzsendesignales. Dies wird durch Anwendung einer sogenannten phasenkohärenten Continuous Phase Frequency Shift Keying Modulation im digitalen Modulator DM bewirkt. Diese ist in Fig. 5 durch die Abtastung mit dem Signal MOD dargestellt. Durch die dabei erzielte Unterdrückung der Phasensprünge wird zwar eine geringfügige Umtastverzögerung verursacht, welche in Fig.5 ebenfalls eingetragen ist. Zur Unterdrückung der Phasensprünge ist eine einfache Logik ausreichend.

Die digitale Ausführung des Modulators hat den Vorteil, daß keine Umschaltung zwischen zwei getrennten, frequenzmäßig verschiedenen, nicht synchronisierbaren Oszillatoren notwendig ist. Eine derartige Ausführung würde eine Vielzahl von Nachteilen aufweisen. So würden bei der Frequenzumtastung zwangsläufig größere Phasensprüngen auftreten. Zu deren Ausgleich müßte die zu übertragende Bandbreite erhöht werden, was wiederum die Störunempfindlichkeit beeinträchtigen würde. Da keine zwei analogen Oszillatoren für die Erzeugung der beiden Kennfrequenzen verwendet werden, treten auch keine Einschwingzeiten auf, welche im Bereich von Millisekunden liegen können. Derartige Einschwingzeiten würden von zwei getrennten Oszillatoren jeweils benötigt werden, da diese bei der Umschaltung zwischen jedesmal neu einschwingen müßten. Vielmehr beruht das erfinderische Konzept auf einem digitalen Modulator, der einen einzigen, vom zentralen Präzisionstakt T getriebenen digitalen Frequenzgenerator aufweist. Dieser kann nahezu verzögerungsfrei zwischen Ober- und Unterfrequenz umgeschaltet werden.

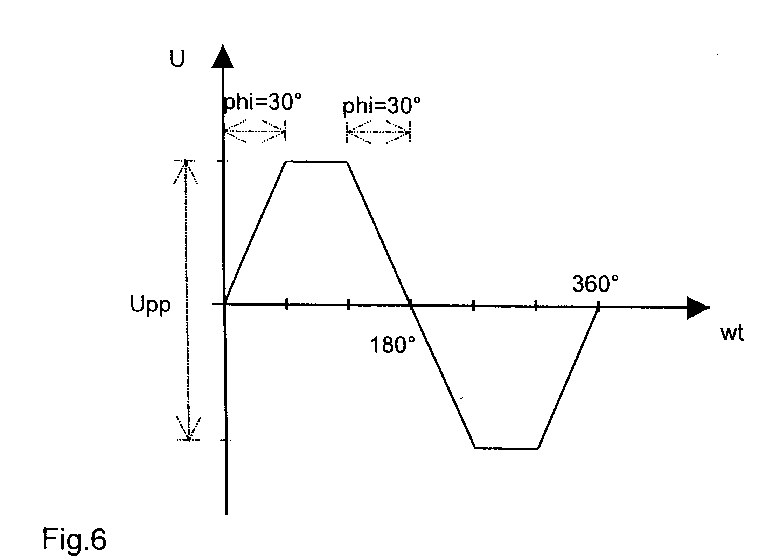

Es ist vorteilhaft, wenn auf der Sendeseite S auf den digitalen Modulator DM noch ein Tiefpaßfilter TP folgt. Hierdurch kann das Auftreten von insbesondere bei der weiteren Signalverarbeitung störenden hohen Frequenzen von vorne herein begrenzt werden. Bevorzugt enthält das Tiefpaßfilter TP zusätzlich einen Trapezgenerator. Hierdurch wird das Sendesignal in eine symmetrische Trapezsignalform umgewandelt. In Fig.6 ist das Sendesignal einer vorteilhaften Ausführungsform eines derartigen Tiefpaßfilters TP am Ausgang des Sendeteiles S der erfindungsgemäßen Modemschaltung dargestellt. Das Tiefpaßfilter stellt zugleich die Schnittstelle zwischen dem digitalen Teil D und dem analogen Teil A dar. Dies hat den Vorteil, daß die weitere Verarbeitung des nun quasianalogen Sendesignales, insbesondere dessen Filterung auf der Empfangsseite einer anderen Modemschaltung, erheblich erleichtert wird. Möglicherweise störende Oberschwingungen treten somit gar nicht erst auf. So entfällt aufgrund der Trapezform die 3. harmonische Oberschwingung, und die 5. harmonische Oberschwingung ist bereits erheblich gedämpft. Dieser Trapezgenerator im Tiefpaßfilter läßt sich mit nur einem Operationsverstärker realisieren. Ein anschließender einfacher Tiefpaß 2. Ordnung ist ausreichend, um die harmonischen Schwingungen im oberen Bereich nochmals zu unterdrücken. Dieser Tiefpaß 2. Ordnung läßt sich ebenfalls mit einem Operationsverstärker mit RC-Beschaltung realisieren. Mit diesem Schaltungskonzept läßt sich mit nur zwei Operationsverstärkern aus einem Rechtecksignal ein frequenzmoduliertes, oberschwingungsarmes und somit leicht übertrag-und demodulierbares Sinussignal erzeugen.

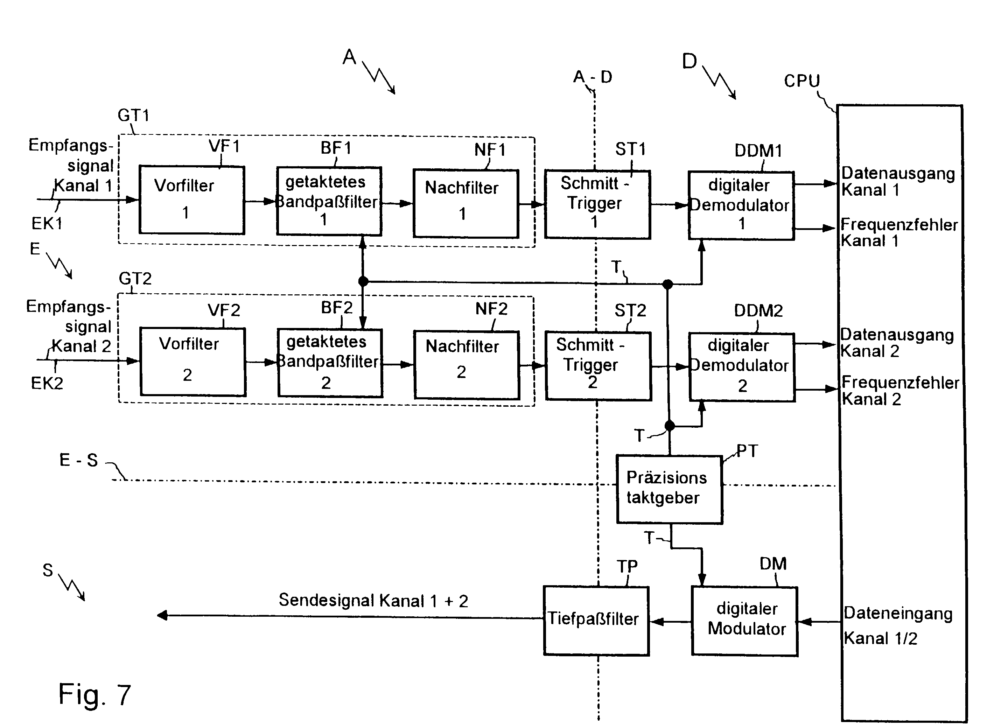

Fig. 7 zeigt schließlich eine zweikanalige Ausführung der erfindungsgemäßen Modemschaltung. Der Kanal 1 auf der Empfangsseite E besteht dabei aus einem getakteten Bandpaßfilter GT1, einem Schmitt-Trigger ST1 und einem digitalen Demodulator DDM1. Das getakteten Bandpaßfilter GT1 besteht wiederum vorteilhaft aus einer Kette, welche ein Vorfilter VF1, ein getaktetes Bandpaßfilter BF1 und ein Nachfilter NF1 enthält. Der Kanal 2 auf der Empfangsseite E besteht dabei in gleicher Weise aus einem getakteten Bandpaßfilter GT2, einem Schmitt-Trigger ST2 und einem digitalen Demodulator DDM2. Das getakteten Bandpaßfilter GT2 besteht wiederum vorteilhaft aus einer Kette, welche ein Vorfilter VF2, ein getaktetes Bandpaßfilter BF2 und ein Nachfilter NF2 enthält. Eine derartige von analogen Empfangssignalen gleichzeitig aus zwei Senderichtungen möglich ist. Dieser Fall tritt insbesondere an den Verbindungsstellen der Schirmungen von zwei Energieversorgungskabeln auf.

## Patentansprüche

1. Vorrichtung zur störsicheren Modulation und Demodulation von analogen Signalen, welche frequenzmoduliert über die Schirmungen von Energieübertragungskabeln übertragen werden, wobei
a) auf einer Empfangsseite (E) zumindest eine Reihenschaltung aus einem getakteten Bandpaßfilter (GT), einem Schmitt-Trigger (ST) und einem digitalen Demodulator (DDM), und auf einer Sendeseite (S) zumindest einen digitalen Modulator (DM) vorhanden ist, und
b) Mittel (PT;CPU) zur Erzeugung eines zentralen Präzisionstaktes (T) vorhanden sind, welcher zumindest dem getakteten Bandpaßfilter (GT) und dem digitalen Demodulator (DDM) auf der Empfangsseite (E), und dem digitalen Modulator (DM) auf der Sendeseite (S) als eine gemeinsame Zeitbasis zugeführt wird.

2. Vorrichtung nach Anspruch 1, wobei der digitale Modulator (DM) auf der Sendeseite (S) mindestens einen vom zentralen Präzisionstaktes (T) getriebenen digitalen Frequenzgenerator enthält, der die Kennfrequenzen (FL,FH) für die Frequenzmodulation zu sendender Vorgabewerte hochgenau aus dem Präzisionstakt (T) ableitet.

3. Vorrichtung nach Anspruch 2, wobei zu sendende digitale Vorgabewerte im digitalen Modulator (DM) durch modulationsgesteuerte Umtastung des digitalen Frequenzgenerators zwischen einer Ober- und einer Unterfrequenz als Kennfrequenzen einer FSK-Modulation unterzogen werden.

4. Vorrichtung nach Anspruch 2 oder 3, wobei der digitale Frequenzgenerator im digitalen Modulator (DM) phasenkohärent nur bei Auftreten eines Nulldurchganges bei einer der Kennfrequenzen zwischen Ober- und Unterfrequenz umtastet.

5. Vorrichtung nach einem der vorangegangenen Ansprüche, wobei dem digitalen Modulator (DM) auf der Sendeseite (S) ein Tiefpaßfilter (TP) nachgeschaltet ist.

6. Vorrichtung nach Anspruch 5, wobei das Tiefpaßfilter (TP) einen Trapezgenerator enthält.

7. Vorrichtung nach einem der vorangegangenen Ansprüche, wobei das getaktete Bandpaßfilter (GT) als getaktetes Kondensatorfilter ausgeführt ist und die Mittenfrequenz des Bandpaßfilters (GT) vom zentralen Präzisionstakt (T) bestimmt wird.

8. Vorrichtung nach einem der vorangegangenen Ansprüche, wobei dem getakteten Bandpaßfilter (GT) ein Vorfilter (VF) vorgeschaltet ist, welches als aktives kontinuierliches Bandpaßfilter bevorzugt 1. Ordnung ausgeführt ist.

9. Vorrichtung nach Anspruch 8, wobei das Vorfilter (VF) Mittel zur Einstellung der Verstärkung der Signalpegel aufweist.

10. Vorrichtung nach einem der vorangegangenen Ansprüche, wobei dem getakteten Bandpaßfilter (GT) ein Nachfilter (VF) nachgeschaltet ist, welches als aktives kontinuierliches Bandpaßfilter bevorzugt 1. Ordnung ausgeführt ist.

11. Vorrichtung nach einem der vorangegangenen Ansprüche, wobei der digitale Demodulator (DDM) einen Referenzzähler zur Auszählung der Periodendauern analoger Empfangssignale (EK) enthält, dessen Zähltakt vom zentralen Präzisionstakt (T) bestimmt wird.

12. Vorrichtung nach Anspruch 11, wobei am Eingang des digitalen Demodulators (DDM) ein Flip-Flop mit pegelsensitiven Set- und Reset-Eingängen vorhanden ist.

13. Vorrichtung nach einem der vorangegangenen Ansprüche, wobei der Schmitt-Trigger (ST) für die Erzeugung einer Schalthysterese Mittel zur Vorgabe einer Schwellspannung (± Uh) aufweist.

## Claims

1. Apparatus for the interference-immune modulation and demodulation of analog signals which are transmitted in a frequency-modulated manner via the screens of power transmission cables, in which
a) at least a series circuit formed by a clocked bandpass filter (GT), a Schmitt trigger (ST) and a digital demodulator (DDM) is present at a receiving end (E), and at least a digital modulator (DM) is present at a transmitting end (S), and
b) means (PT; CPU) for generating a central precision clock signal (T) are present, which precision clock signal is fed as a common time base at least to the clocked bandpass filter (GT) and to the digital demodulator (DDM) at the receiving end (E) and to the digital modulator (DM) at the transmitting end (S) .

2. Apparatus according to Claim 1, in which the digital modulator (DM) at the transmitting end (S) contains at least one digital frequency generator which is driven by the central precision clock signal (T) and derives the characteristic frequencies (FL, FH) for the frequency modulation of selection values to be transmitted from the precision clock signal (T) with high accuracy.

3. Apparatus according to Claim 2, in which digital selection values to be transmitted are subjected to FSK modulation in the digital modulator (DM) by means of modulation-controlled keying of the digital frequency generator between an upper and a lower frequency as characteristic frequencies.

4. Apparatus according to Claim 2 or 3, in which the digital frequency generator in the digital modulator (DM) switches over between the upper and lower frequencies in a phase-coherent manner only upon the occurrence of a zero crossing in one of the characteristic frequencies.

5. Apparatus according to one of the preceding claims, in which a low-pass filter (TP) is connected downstream of the digital modulator (DM) at the transmitting end (S).

6. Apparatus according to Claim 5, in which the low-pass filter (TP) contains a trapezium generator.

7. Apparatus according to one of the preceding claims, in which the clocked bandpass filter (GT) is designed as a clocked capacitor filter and the mid-frequency of the bandpass filter (GT) is determined by the central precision clock signal (T).

8. Apparatus according to one of the preceding claims, in which a prefilter (VF) which is designed as an active continuous bandpass filter, preferably a 1st-order one, is connected upstream of the clocked bandpass filter (GT).

9. Apparatus according to Claim 8, in which the prefilter (VF) has means for setting the gain of the signal levels.

10. Apparatus according to one of the preceding claims, in which a postfilter (VF) which is designed as an active continuous bandpass filter, preferably a 1st-order one, is connected downstream of the clocked bandpass filter (GT).

11. Apparatus according to one of the preceding claims, in which the digital demodulator (DDM) contains a reference counter for counting out the periods of analog reception signals (EK), the counting clock signal of which counter is determined by the central precision clock signal (T).

12. Apparatus according to Claim 11, in which a flip-flop having level-sensitive set and reset inputs is present at the input of the digital demodulator (DDM).

13. Apparatus according to one of the preceding claims, in which the Schmitt trigger (ST) has means for predetermining a threshold voltage (± Uh), for producing a switching hysteresis.

## Revendications

1. Dispositif pour la modulation et la démodulation sans bruit de signaux analogiques qui sont transmis modulés en fréquence via les blindages de câbles de transport d'énergie,
a) dans lequel il y a du côté récepteur (E) au moins un circuit série composé d'un filtre passe-bande cadencé (GT), d'un trigger de Schmitt (ST) et d'un démodulateur numérique (DDM) et du côté émetteur (S) au moins un modulateur numérique (DM), et
b) dans lequel il y a des moyens (PT ; CPU) pour produire une horloge centrale de précision (T) qui est envoyée comme base de temps commune au moins au filtre passe-bande cadencé (GT) et au démodulateur numérique (DDM) du côté récepteur (E) et au modulateur numérique (DM) du côté émetteur (S).

2. Dispositif selon la revendication 1, dans lequel le modulateur numérique (DM) du côté émetteur (S) contient au moins un générateur numérique de fréquence qui est soumis à l'horloge centrale de précision (T) et qui déduit de l'horloge de précision (T) très précisément les fréquences significatives (FL, FH) pour la modulation de fréquence de valeurs données à émettre.

3. Dispositif selon la revendication 2, dans lequel des valeurs données numériques à émettre sont soumises dans le modulateur (DM) à une modulation FSK à travers une commutation, commandée par modulation, du générateur numérique de fréquence entre une fréquence haute et une fréquence basse comme fréquences significatives.

4. Dispositif selon la revendication 2 ou 3, dans lequel le générateur numérique de fréquence dans le modulateur numérique (DM) commute entre fréquence haute et fréquence basse avec une cohérence de phase seulement lors de l'apparition d'un passage par zéro pour une des fréquences significatives.

5. Dispositif selon l'une des revendications précédentes, dans lequel un filtre passe-bas (TP) est branché du côté aval du modulateur numérique (DM) du côté émetteur (S).

6. Dispositif selon la revendication 5, dans lequel le filtre passe-bas (TP) contient un générateur de trapèze.

7. Dispositif selon l'une des revendications précédentes, dans lequel le filtre passe-bande cadencé (GT) est mis en oeuvre sous forme de filtre à capacités commutées et dans lequel la fréquence centrale du filtre passe-bande (GT) est déterminée par l'horloge centrale de précision (T).

8. Dispositif selon l'une des revendications précédentes, dans lequel un préfiltre (VF) est branché du côté amont du filtre passe-bande cadencé (GT) et est mis en oeuvre sous la forme d'un filtre passe-bande actif, continu et de préférence de 1er ordre.

9. Dispositif selon la revendication 8, dans lequel le préfiltre (VF) comporte des moyens pour régler l'amplification du niveau de signal.

10. Dispositif selon l'une des revendications précédentes, dans lequel un postfiltre (NF) est branché du côté aval du filtre passe-bande cadencé (GT) et est mis en oeuvre sous la forme d'un filtre passe-bande actif, continu et de préférence de 1er ordre.

11. Dispositif selon l'une des revendications précédentes, dans lequel le démodulateur numérique (DDM) contient un compteur de référence qui est destiné à compter les durées de périodes de signaux reçus analogiques (EK) et dont l'horloge de comptage est déterminée par l'horloge centrale de précision (T).

12. Dispositif selon la revendication 11, dans lequel il y a à l'entrée du démodulateur numérique (DDM) une bascule bistable comportant des entrées Set et Reset sensibles au niveau.

13. Dispositif selon l'une des revendications précédentes, dans lequel le trigger de Schmitt (ST) pour la production d'une hystérésis de commutation comporte des moyens pour donner une tension de seuil (± Uh).
